# EUROPÄISCHE PATENTANMELDUNG

(11) **EP 3 723 123 A1**
(43) Veröffentlichungstag der Anmeldung: **14.10.2020**
(21) Anmeldenummer: 19168170.9
(22) Anmeldetag: 09.04.2019
(51) Int. Cl.: H01L 23/473

(54) **WÄRMEÜBERTRAGUNGSVORRICHTUNG UND BAUTEIL**

(71) Anmelder: Siemens Aktiengesellschaft, 80333 München (DE)
(72) Erfinder: Schwarz, Florian, 90766 Fürth (DE)

(57) **Zusammenfassung**

Die Erfindung betrifft eine Wärmeübertragungsvorrichtung (1) und ein elektrisches oder elektronisches Bauteil (4), wobei die Wärmeübertragungsvorrichtung (1)
- mindestens eine wärmeableitende Struktur (2) und
- mindestens eine Wärmekammer (3) umfasst,
wobei die wärmeableitende Struktur (2) und die Wärmekammer (3) zu einem geschlossenen thermischen Kreislauf (7) gekoppelt sind,
wobei die wärmeableitende Struktur (2)
- einen Ausgangskanal (2.1) umfasst, der von der Wärmekammer (3) abgeht und der an einem von der Wärmekammer (3) abgewandten Ende (2.2) in mindestens einen Rücklaufkanal (2.3) mündet, und
wobei der Rücklaufkanal (2.3) kleiner dimensioniert ist als der Ausgangskanal (2.1) und in die Wärmekammer (3) mündet.

## Beschreibung

Die Erfindung betrifft eine Wärmeübertragungsvorrichtung und ein elektrisches oder elektronisches Bauteil.

Elektrische oder elektronische Bauteile können Teil einer integrierten Schaltung sein, die auf einer Trägerplatte angeordnet ist. Dabei können die elektrischen oder elektronischen Bauteile, wie zum Beispiel ein Widerstand oder ein Leistungshalbleiter, Wärme erzeugen, die nicht hinreichend genug über die Trägerplatte abgeführt werden kann. Daher sind im Stand der Technik Kühlplatten bekannt, welche zwischen dem elektrischen/elektronischen Bauteil und der Trägerplatte oder an der Trägerplatte zur thermischen Kopplung angeordnet sind, um die Wärme vom elektrischen/elektronischen Bauteil wegzuführen.

Die Leistungsdichte und ein damit verbundener zulässiger Einsatzbereich von elektrischen/elektronischen Bauteilen sind durch die sogenannte Sperrschichttemperatur von Halbleiterelementen, aus welchen die elektrischen oder elektronischen Bauteile gebildet sind, beschränkt. Eine maximal zulässige Temperatur schränkt daher den Einsatz und Aufbau des elektrischen oder elektronischen Bauteils ein. Darüber hinaus wird durch starke Temperaturwechsel die Lebensdauer von Halbleiterelementen und deren Anbindung und damit die des gesamten elektrischen oder elektronischen Bauteils reduziert. Daher ist die thermische Anbindung an das elektrische oder elektronische Bauteil und insbesondere an dessen Halbleiterelemente von großer Bedeutung. Die thermische Anbindung wird insbesondere durch folgende Parameter beeinflusst: Größe der Kühl- und Kontaktfläche zum elektrischen oder elektronischen Bauteil, Stoffparameter (z. B. Wärmeleitkoeffizient), den Wärmeübergangskoeffizient und den Temperaturunterschied zwischen Wärmequelle (zum Beispiel Halbleiterelement des elektrischen oder elektronischen Bauteils) und Wärmesenke (zum Beispiel Kühlelement).

Um die thermische Anbindung zu verbessern, ist es daher bekannt, die am elektrischen oder elektronischen Bauteil entstehende Wärme auf eine große Fläche zu spreizen. Hierzu ist eine Wärmeübertragungsvorrichtung bekannt, welche eine zentrale Wärme-, insbesondere eine Dampfkammer, umfasst, von der symmetrisch Mikrokanäle abgehen und die nach dem Prinzip einer pulsierenden Heizstruktur (heat-pipe principle) infolge einer gepumpten Kühlung arbeiten. Eine solche Wärmeübertragungsvorrichtung ist beispielsweise im International Journal of Heat and Mass Transfer 81, 2015, Seiten 33 bis 40, Artikel: "Heat transfer performance of a fractal silicon microchannel heat sink subjected to pulsation flow" von S. Xu et al. (Shanglong Xu, Weijie Wang, Juang Fang, Chun-Nam Wong), journal homepage: www.elsevier.com/locate/ijhmt beschrieben.

Befindet sich dabei zu viel Flüssigkeit innerhalb der Wärmekammer, kann die pulsierende Heizstruktur nicht starten. Befindet sich zu viel Dampf innerhalb der Wärmekammer, kann das elektrische/elektronische Bauteil überhitzen.

Der Erfindung liegt daher die Aufgabe zugrunde, eine Wärmeübertragungsvorrichtung anzugeben, welche eine Wärmeübertragung und -ableitung sicher ermöglicht, insbesondere ein sicheres Starten der Wärmeübertragungsvorrichtung.

Die Aufgabe wird erfindungsgemäß durch eine Wärmeübertragungsvorrichtung mit den Merkmalen des Patentanspruchs 1 gelöst. Hinsichtlich des elektronischen Bauteils wird die Aufgabe erfindungsgemäß durch die Merkmale des Patentanspruchs 12 gelöst.

Weiterbildungen der Erfindung sind Gegenstand der abhängigen Patentansprüche.

Die Wärmeübertragungsvorrichtung umfasst erfindungsgemäß mindestens eine wärmeableitende Struktur und mindestens eine Wärme-, insbesondere Heißkammer, wobei die wärmeableitende Struktur und die Wärmekammer zu einem geschlossenen thermischen Kreislauf gekoppelt sind, wobei die wärmeableitende Struktur einen Ausgangskanal umfasst, der von der Wärmekammer abgeht und der an einem von der Wärmekammer abgewandten Ende in mindestens einen Rücklaufkanal mündet, und wobei der Rücklaufkanal kleiner dimensioniert ist als der Ausgangskanal und in die Wärmekammer mündet.

Eine solche Wärmeübertragungsvorrichtung mit einer solchen wärmeableitenden Struktur in Form einer Kanal-, insbesondere Mikrokanal- oder Kapillarstruktur ist gekennzeichnet durch eine Wärmesenke mit großer Wärmeübertragungsfläche, wobei bei einer pulsierenden oder oszillierenden Strömung eines Fluids, wie eines Kühlmediums, durch die wärmeableitende Struktur zusätzlich eine konvektive Wärmeübertragung ermöglicht ist. Die Ausgestaltung eines größer dimensionierten Ausgangskanals, der von der Wärme- oder Heißkammer abgeht, ermöglicht eine verbesserte Aufteilung und Abführung eines Wärmestromes aus der Wärmekammer heraus, wodurch ein verbesserter Wärmeabtransport gegeben ist.

Ein weiterer Aspekt sieht vor, dass sich der Ausgangskanal an dem von der Wärmekammer abgewandten Ende in mindestens zwei oder mehr Rücklaufkanäle aufteilt, welche jeweils kleiner dimensioniert sind als der Ausgangskanal und welche getrennt voneinander in die Wärmekammer münden. Eine solche Auslegung und Aufteilung des Wärmestroms des Ausgangskanals in zwei oder mehr Rücklaufkanäle ermöglicht einen verbesserten Wärmetransport und eine verbesserte Kondensation. Dabei können die Rücklaufkanäle und der Ausgangskanal derart ausgelegt sein, dass der Massenstrom des Ausgangskanals gleich der Summe der Teilmassenströme der Rücklaufkanäle ist.

Ein weiterer Aspekt sieht vor, dass die kleineren Rücklaufkanäle im Bereich eines äußeren Randes der Wärmeübertragungsvorrichtung fraktal aufgeteilt oder weiterverzweigt sind, insbesondere in weitere Teilrücklaufkanäle aufgeteilt sind. Hierdurch ist eine Strömungsteilung mit minimalem Druckverlust bei gleichzeitig maximaler Flächennutzung und -aufspreizung gegeben. Dies führt zu einer verbesserten Kondensation in den Rücklaufkanälen und damit einer verbesserten Wärmeübertragung.

Eine weitere mögliche Ausführungsform sieht vor, dass der Ausgangskanal und der mindestens eine Rücklaufkanal in einer Ebene liegen. Dies ermöglicht einen flachen Aufbau der Wärmeübertragungsvorrichtung.

Eine alternative Ausführungsform sieht vor, dass der Ausgangskanal in mindestens einer ersten Ebene verläuft und der mindestens eine Rücklaufkanal in mindestens einer zu der ersten Ebene versetzten zweiten Ebene verläuft. Mit anderen Worten: Der Rücklaufkanal oder die Rücklaufkanäle werden eine oder mehrere Ebene/n tiefer zurückgeführt. Dadurch entsteht eine wärmeableitende Struktur mit mindestens zwei oder mehreren übereinander liegenden Kanalstrukturen - mindestens einer oberen Ausgangskanalstruktur und mindestens einer darunter liegenden Rücklaufkanalstruktur. Darüber hinaus sind weitere fraktale und/oder dreidimensionale Geometrien für die wärmeableitende Struktur möglich. Eine solche dreidimensionale Geometrie für die Wärmeübertragungsvorrichtung erlaubt eine Integration, insbesondere eine thermische Kopplung der Wärmeübertragungsvorrichtung mit einer Rippenstruktur eines zu kühlenden Bauteils.

Eine einfache Ausführungsform sieht vor, dass ein Innendurchmesser des Ausgangskanals größer ist als ein Innendurchmesser des mindestens einen Rücklaufkanals. Dies ermöglicht einen Wärmetransport mit minimalem Druckverlust bei gleichzeitig maximaler Flächennutzung und -aufspreizung. Darüber hinaus ermöglicht eine solche Querschnittsverengung vom Ausgangskanal in den anschließenden Rücklaufkanal eine Strömungsbeschleunigung. Dies bewirkt eine pulsierende oder oszillierende Strömung im geschlossenen thermischen Kreislauf.

Ein weiterer Aspekt sieht vor, dass die Wärme- oder Heißkammer als eine Siede- oder Dampfkammer ausgebildet ist, welche an mindestens einer oder einander gegenüberliegenden Innenoberflächen mit einer Struktur versehen ist. Durch eine solche innenseitige Oberflächenstruktur, die in die Wärmekammer hineinragt, kann ein optimales Verhältnis von Fluid/Flüssigkeit und Dampf in der Wärmekammer eingestellt werden. Beispielsweise ist die Struktur derart ausgebildet, dass ein Innenraum der Wärme-, insbesondere einer Siede- oder Dampfkammer, einen variierenden Querschnitt aufweist.

Beispielsweise kann ein Innenraum der Wärmekammer, insbesondere einer Siede- oder Dampfkammer, entlang ihrer Längsausdehnung, zum Beispiel einer horizontalen Ausdehnung der Wärmekammer, mehrere Verengungen aufweisen, die voneinander beabstandet sind. Durch derartige punktuelle Querschnittsveränderungen, insbesondere Verengungen, wie Querschnittsverengungen, erhöht sich die sogenannte Kapillarkraft in der Wärmekammer.

In einer möglichen Ausführungsform sind die Verengungen, wie zum Beispiel Querschnittsverengungen, durch einander gegenüberliegende Vorsprünge gebildet, die von einander gegenüberliegenden Innenoberflächen, wie zum Beispiel Innenraumwänden, in den Innenraum hineinragen. Solch ein Muster von inneren Strukturen im Innenraum der Wärme- oder Heißkammer erleichtert das sogenannte Anfahren bei einem eingefrorenen Fluid, wie einem Kühlmedium, zum Beispiel einem Kühlfluid oder - mittel.

Ein weiter Aspekt sieht vor, dass die mindestens eine Wärme- oder Heißkammer eine Siede- oder Dampfkammer ist und die mindestens eine wärmeableitende Struktur eine Kanalstruktur mit Dampfbereichen und Flüssigbereichen ist, wobei die Wärmekammer und die wärmeableitende Struktur zusammen einen pulsierenden oder oszillierenden Heizstrukturmechanismus (auch pulsating heat-pipe mechanism genannt) mit einer Zwei-Phasen-Strömung bilden.

Beim pulsierenden Heizstrukturmechanismus (pulsating heat-pipe mechanism) erfolgt eine pulsierende oder oszillierende Führung und Rückführung des Fluids, wie eines Kühlmediums, mittels Kapillarkräften in den Kanälen, wie dem Ausgangskanal und den Rücklaufkanal, einem Wärmerohr oder einer sogenannten Pulsating Heat-Pipe. Der pulsierende Heizstrukturmechanismus stellt eine effiziente Wärmetransportmöglichkeit dar. Dabei verdampft beispielsweise das Fluid, insbesondere ein Kühlmedium, zum Beispiel Wasser, Aceton, Methanol oder Ethanol, dort, wo die Wärme aufgenommen wird im Bereich einer Wärmeaufnahme des Fluids, beispielsweise in der Wärmekammer, und damit im Bereich eines Leistungselements des elektrischen oder elektronischen Bauteils und kondensiert beispielsweise dort, wo die Wärme abgegeben wird, beispielsweise bereits in der Wärmekammer und/oder der wärmeableitenden Struktur, insbesondere einer symmetrischen oder asymmetrischen Kanalstruktur. Es wird also ein Wärmetransport durch Ausnutzung von Enteisung, Verdampfung, Verdunstung oder jeglicher Art der Phasenumwandlung erzeugt. Die Wärmeaufnahme in das Fluid führt zu einer Erhöhung des Energieniveaus des Fluides, insbesondere des Drucks im thermischen Kreislauf und infolge dessen zu einem Phasenübergang des Fluides, beispielsweise von fest zu flüssig oder von flüssig zu gasförmig oder umgekehrt.

Damit liegt das Fluid, wie ein Kühlmedium oder -mittel, in dem geschlossenen Kreislauf in zwei Phasen vor. Darüber hinaus ist die wärmeableitende Struktur, insbesondere eine Kanal-, beispielsweise eine Mikrokanal- oder Kapillarstruktur, symmetrisch um die Wärmekammer angeordnet. Darüber hinaus werden die Wärmekammer und die wärmeableitende Struktur zunächst vakuumiert und anschließend teilweise mit dem Fluid, einem Kühlmedium, befüllt. Dadurch liegen bereits zu Beginn eines Betriebs der Wärmeübertragungsvorrichtung zwei Phasen im Kreislauf vor.

Ein weiterer Aspekt sieht vor, dass die Wärmeübertragungsvorrichtung mehr als eine Wärmekammer umfassen kann, welche Teil eines einzelnen geschlossenen thermischen Kreislaufs sind. Alternativ kann jede Wärmekammer einen zugehörigen geschlossenen thermischen Teilkreislauf aufweisen, wobei die geschlossenen thermischen Teilkreisläufe wiederum thermisch indirekt oder direkt gekoppelt sein können. Alternativ können die thermischen Teilkreisläufe auch voneinander getrennt sein. Ferner können die Kanäle der wärmeableitenden Struktur asymmetrisch um eine oder mehrere Wärmekammer/n angeordnet sein.

Ein weiterer Aspekt der Erfindung betrifft ein elektrisches oder elektronisches Bauteil, welches ein Leistungselement, insbesondere einen Leistungshalbleiter, umfasst, welches thermisch mit einer Wärmeübertragungsvorrichtung gekoppelt ist.

In einer möglichen Ausführungsform kann die Wärmeübertragungsvorrichtung unterhalb, oberhalb oder innerhalb des Leistungselements angeordnet sein. Dies ermöglicht eine direkte und schnelle Wärmeübertragung und damit eine schnelle Entwärmung des heißen Leistungselements. Beispielsweise ist die Wärmekammer unterhalb des Leistungselements parallel zu diesem angeordnet.

Die wärmeableitende Struktur erstreckt sich dabei radial weg von der Wärmekammer und dem Leistungselement in einer oder mehreren Ebene/n. Dies ermöglicht eine verbesserte Flächenausnutzung und -aufspreizung für einen verbesserten Wärmetransport und eine verbesserte Wärmeübertragung.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung von Ausführungsbeispielen, die im Zusammenhang mit den Zeichnungen näher erläutert werden. Dabei zeigen:
- FIG 1: schematisch in Schnittdarstellung eine Wärmeübertragungsvorrichtung, die unterhalb eines elektrischen oder elektronischen Bauteils angeordnet ist,
- FIG 2: schematisch in perspektivischer Darstellung eine Wärmeübertragungsvorrichtung mit einem elektrischen oder elektronischen Bauteil,
- FIG 3: schematisch in Draufsicht eine Wärmekammer mit einer wärmeableitenden Struktur, die miteinander zu einem geschlossenen thermischen Kreislauf verbunden sind,
- FIG 4 bis FIG 7: schematisch in Draufsicht jeweils eine Wärmekammer mit einer alternativen wärmeableitenden Struktur, die miteinander zu einem geschlossenen thermischen Kreislauf verbunden sind,
- FIG 8: schematisch in Schnittdarstellung eine Wärmekammer mit einer innenseitigen Oberflächenstruktur,
- FIG 9: schematisch in Schnittdarstellung eine Wärmekammer mit einer innenseitigen Oberflächenstruktur und eine daraus resultierende verbesserte, insbesondere symmetrische Fluidbesetzung in der Wärmekammer, und
- FIG 10: schematisch in Schnittdarstellung eine herkömmliche Wärmekammer ohne innenseitige Oberflächenstruktur und eine daraus resultierende unsymmetrische Fluidbesetzung in der Wärmekammer nach dem Stand der Technik.

Einander entsprechende Teile sind in allen Figuren mit den gleichen Bezugszeichen versehen.

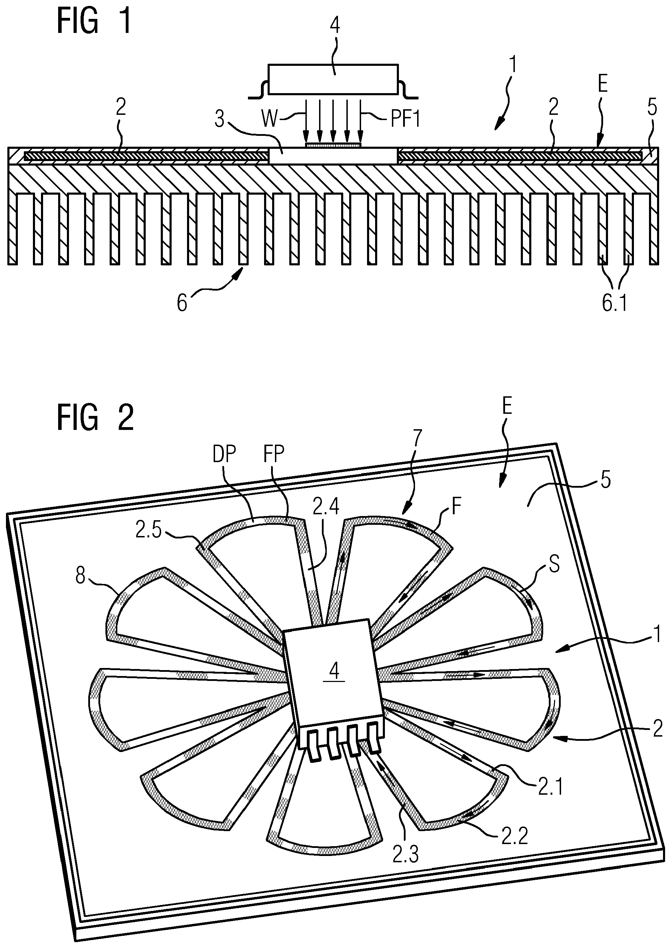

FIG 1 zeigt schematisch in Schnittdarstellung eine Wärmeübertragungsvorrichtung 1.

Die Wärmeübertragungsvorrichtung 1 umfasst mindestens eine wärmeableitende Struktur 2 und mindestens eine Wärmekammer 3. Die Wärmeübertragungsvorrichtung 1 ist unterhalb eines elektrischen oder elektronischen Bauteils 4 (im Weiteren kurz Bauteil 4 genannt) angeordnet. Alternativ kann die Wärmeübertragungsvorrichtung 1 auch oberhalb oder innerhalb des Bauteils 4 angeordnet sein (nicht näher dargestellt).

Das Bauteil 4 ist zum Beispiel Teil einer integrierten Schaltung, die wiederum Teil einer Trägerplatte 5, insbesondere einer Leiterplatte, ist. Beispielsweise ist das Bauteil 4 ein Leistungselement, insbesondere ein Leistungshalbleiterelement, welches im Betrieb Wärme W erzeugt und diese gemäß Pfeil PF1 abstrahlt.

Optional kann zur Wärmeabführung ein Kühlkörper 6 vorgesehen sein, der beispielsweise auf einer zum Bauteil 4 gegenüberliegenden Seite der Trägerplatte 5 angeordnet ist. Der Kühlkörper 6 kann zur Verteilung und verbesserten Abführung der Wärme W Rippen 6.1 aufweisen, wodurch die Wärme W auf eine große Fläche verteilt und abgeführt wird.

FIG 2 zeigt schematisch in perspektivischer Darstellung eine mögliche Ausführungsform für die Wärmeübertragungsvorrichtung 1 mit einem elektrischen oder elektronischen Bauteil 4, insbesondere einem Leistungshalbleiterelement, wie einem Leistungs-Chip.

Die Wärmeübertragungsvorrichtung 1 umfasst die wärmeableitende Struktur 2 und die Wärmekammer 3, die zu einem geschlossenen thermischen Kreislauf 7 gekoppelt sind, in welchem ein Fluid F, insbesondere ein Kühlmedium, wie zum Beispiel Wasser, Methanol, Ethanol oder Aceton, fließt.

Die Wärmekammer 3 ist insbesondere eine Heißkammer, welche direkt unterhalb des Bauteils 4 angeordnet ist und welche durch die abstrahlende Wärme W des Bauteils 4 thermisch beansprucht wird. Je nach Grad der abstrahlenden Wärme W kann das in der Wärmekammer 3 angeordnete Fluid F bis zum Siedepunkt oder Verdampfungspunkt erhitzt werden, wodurch der Druck im thermischen Kreislauf 7 erhöht wird und sich eine pulsierende Strömung S in dem thermischen Kreislauf 7 mit Flüssigphasen FP oder Dampfphasen DP ohne eine Pumpe einstellt. Dabei befindet sich der thermische Kreislauf 7 nach einer teilweisen Befüllung mit dem Fluid F im thermodynamischen Gleichgewicht, in welchem beide Phasen - Flüssigphase FP und Dampfphase DP - vorliegen. Durch eine punktuelle Erwärmung erhöht sich der Druck im thermischen Kreislauf 7. Dies führt zu der pulsierenden oder oszillierenden Strömung S ohne Pumpe. Dabei kann das Fluid F stellenweise verdampfen und kondensieren, wodurch der Wärmetransport erhöht wird. Die pulsierende oder oszillierende Strömung S (im Weiteren kurz pulsierende Strömung S genannt) ist somit eine Zweiphasenströmung, in welcher entlang des geschlossenen thermischen Kreislaufs 7 das Fluid F in Flüssigphasen FP und/oder Dampfphasen DP vorliegt. Somit weist die wärmeableitende Struktur 2 Dampfbereiche 2.4 und Flüssigbereiche 2.5 auf.

Die Wärmekammer 3 kann je nach Phase des Fluides F auch als Dampf- oder Siedekammer bezeichnet werden.

Die wärmeableitende Struktur 2 umfasst einen Ausgangskanal 2.1, der von der Wärmekammer 3 abgeht und der an einem von der Wärmekammer 3 abgewandten Ende 2.2 in mindestens einen Rücklaufkanal 2.3 mündet, der dann in die Wärmekammer 3 mündet.

Beispielsweise strömt das aus der Wärmekammer 3 ausströmende Fluid F über den Ausgangskanal 2.1 und den Rücklaufkanal 2.3 in die Wärmekammer 3 in Art einer Kühlschleife 8 zurück, wodurch der geschlossene thermische Kreislauf 7 gebildet ist.

Dabei können mehrere Kühlschleifen 8 um die, insbesondere mittige oder zentral angeordnete, Wärmekammer 3 symmetrisch verteilt angeordnet sein. Insbesondere weisen die Kühlschleifen 8 im Wesentlichen gleiche Formen, Größen und Abmessungen auf. Alternativ können diese auch voneinander verschieden sein.

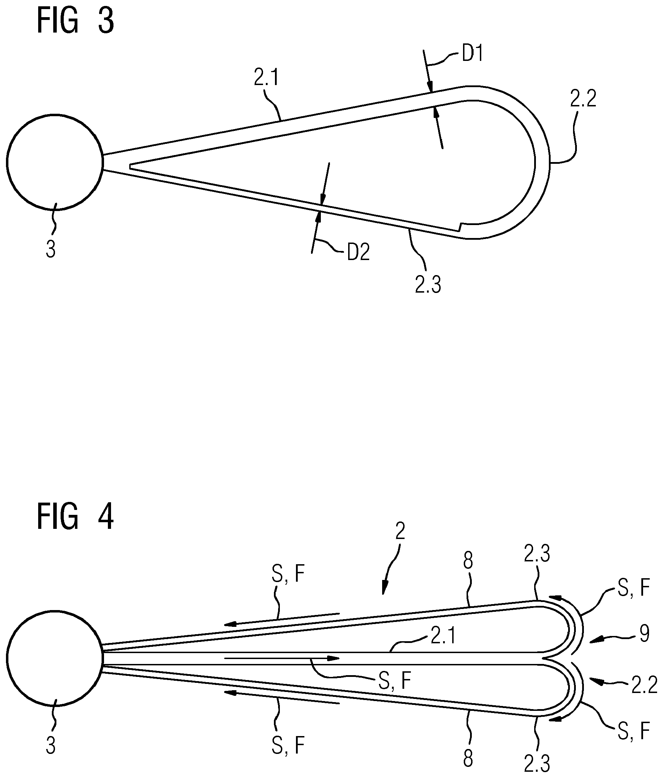

Dabei ist der Rücklaufkanal 2.3 kleiner dimensioniert als der Ausgangskanal 2.1, wie dies in FIG 3 im Detail gezeigt ist.

FIG 3 zeigt im Detail eine der Kühlschleifen 8 des geschlossenen thermischen Kreislaufs 7 mit der zentralen Wärmekammer 3 und der wärmeableitenden Struktur 2, die miteinander zu der Kühlschleife 8 und damit zu einem Teilkreislauf des geschlossenen thermischen Kreislaufs 7 verbunden sind.

Die Ausgestaltung des größer dimensionierten Ausgangskanals 2.1, der von der Wärmekammer 3 abgeht, ermöglicht eine verbesserte Aufteilung und Abführung des Fluidstromes aus der Wärmekammer 3 heraus, wodurch ein verbesserter Wärmeabtransport gegeben ist.

Allen Kühlschleifen 8 ist beispielsweise gleich, dass deren Ausgangskanäle 2.1 größer dimensioniert sind als deren Rücklaufkanäle 2.3.

Beispielsweise ist ein Innendurchmesser D1 des Ausgangskanals 2.1 größer ist als ein Innendurchmesser D2 des Rücklaufkanals 2.3. Dies ermöglicht einen Wärmetransport mit minimalem Druckverlust bei gleichzeitig maximaler Flächennutzung und -aufspreizung. Darüber hinaus ermöglicht eine solche Querschnittsverengung 13 vom Ausgangskanal 2.1 in den anschließenden Rücklaufkanal 2.3 eine Strömungsbeschleunigung. Dies bewirkt und unterstützt die pulsierende Strömung S im geschlossenen thermischen Kreislauf 7.

Eine solche Wärmeübertragungsvorrichtung 1 mit einer solchen wärmeableitenden Struktur 2 in Form einer Kanalstruktur, insbesondere Mikrokanal- oder Kapillarstruktur, ermöglicht eine Wärmesenke mit großer Wärmeübertragungsfläche, wobei aufgrund der pulsierenden Strömung S des Fluids F durch die wärmeableitende Struktur 2 zusätzlich eine konvektive Wärmeübertragung ermöglicht ist.

FIG 4 zeigt schematisch in Draufsicht die Wärmekammer 3 mit einer alternativen wärmeableitenden Struktur 2 in Form einer Doppelkühlschleife 9, gebildet aus zwei einzelnen Kühlschleifen 8.

Dabei teilt sich der Ausgangskanal 2.1 an dem von der Wärmekammer 3 abgewandten Ende 2.2 in mindestens zwei Rücklaufkanäle 2.3 auf, welche jeweils kleiner dimensioniert sind als der Ausgangskanal 2.1 und welche getrennt voneinander in die Wärmekammer 3 münden. Somit sind zwei Kühlschleifen 8 gebildet, welche durch den einen gemeinsamen Ausgangskanal 2.1 und die zwei aufgeteilten Rücklaufkanäle 2.3 gebildet sind. Der gemeinsame Ausgangskanal 2.1 ist dabei größer dimensioniert als die beiden abgehenden Rücklaufkanäle 2.3. Insbesondere weist der gemeinsame Ausgangskanal 2.1 einen größeren Innendurchmesse D1 als der jeweilige Innendurchmesser D2 der Rücklaufkanäle 2.3 auf. Dabei können die Rücklaufkanäle 2.3 im Wesentlichen gleiche Formen, Größen und Abmessungen aufweisen. Insbesondere sind die Innendurchmesser D2 der Rücklaufkanäle 2.3 identisch.

Eine solche Auslegung und Aufteilung der pulsierenden oder oszillierenden Strömung S vom Ausgangskanal 2.1 in zwei oder mehr Rücklaufkanäle 2.3 ermöglicht einen verbesserten Wärmetransport und eine verbesserte Kondensation. Dabei können die Rücklaufkanäle 2.3 und der gemeinsame Ausgangskanal 2.1 derart ausgelegt sein, dass der Massenstrom des Ausgangskanals 2.1 gleich der Summe der Teilmassenströme der Rücklaufkanäle 2.3 ist.

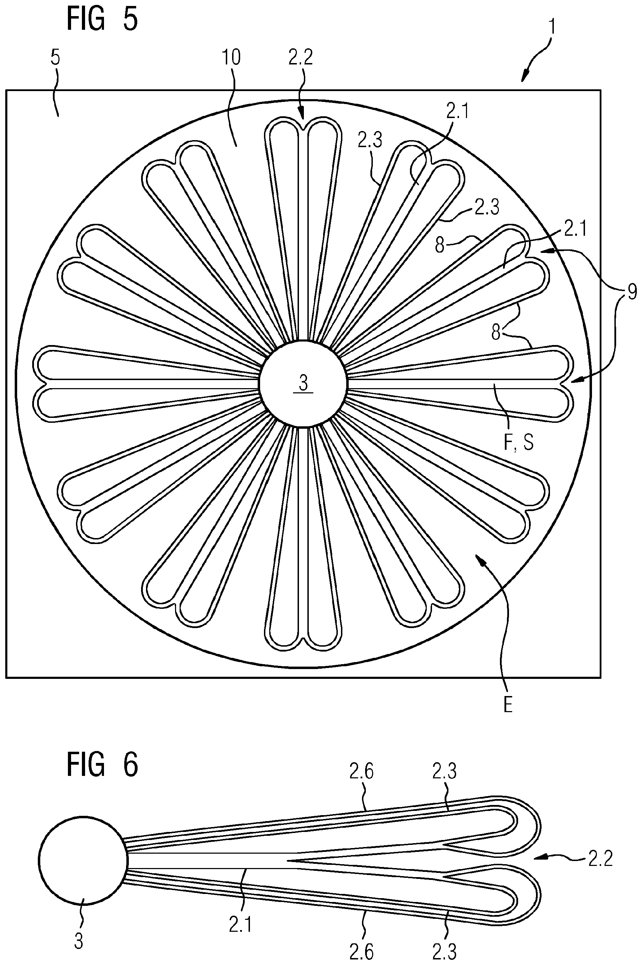

FIG 5 zeigt im Detail die Wärmeübertragungsvorrichtung 1 mit mehreren symmetrisch um die Wärmekammer 3 verteilt angeordneten Doppelkühlschleifen 9 gemäß FIG 4. Die Wärmeübertragungsvorrichtung 1 ist beispielsweise auf einer Grundplatte 10 angeordnet, welche auf der Trägerplatte 5 angeordnet ist. Je nach Ausführungsform können Grundplatte 10 und Trägerplatte 5 ein Bauteil 4 oder separate Bauteile 4 sein.

FIG 6 zeigt schematisch in Draufsicht die Wärmekammer 3 mit einer alternativen wärmeableitenden Struktur 2 mit einer fraktalen Aufteilung der Rücklaufkanäle 2.3 in weitere Teilrücklaufkanäle 2.6.

Dabei teilt sich zunächst der gemeinsame Ausgangskanal 2.1 in zwei Rücklaufkanäle 2.3 auf, von denen jeweils ein Teilrücklaufkanal 2.6 abgeht. Die Kanalaufteilung erfolgt dabei an dem von der Wärmekammer 3 abgewandten Ende 2.2 der wärmeableitenden Struktur 2. Eine solche fraktale Kanalaufteilung ermöglicht eine Strömungsteilung mit minimalem Druckverlust bei gleichzeitig maximaler Flächennutzung und -aufspreizung.

Bei den verschiedenen Ausführungsformen der Wärmeübertragungsvorrichtung 1 nach Figuren 1 bis 6 ist die wärmeableitende Struktur 2 in einer Ebene E angeordnet. Das heißt, die Ausgangskanäle 2.1 und die Rücklaufkanäle 2.3 verlaufen in der gleichen Ebene E.

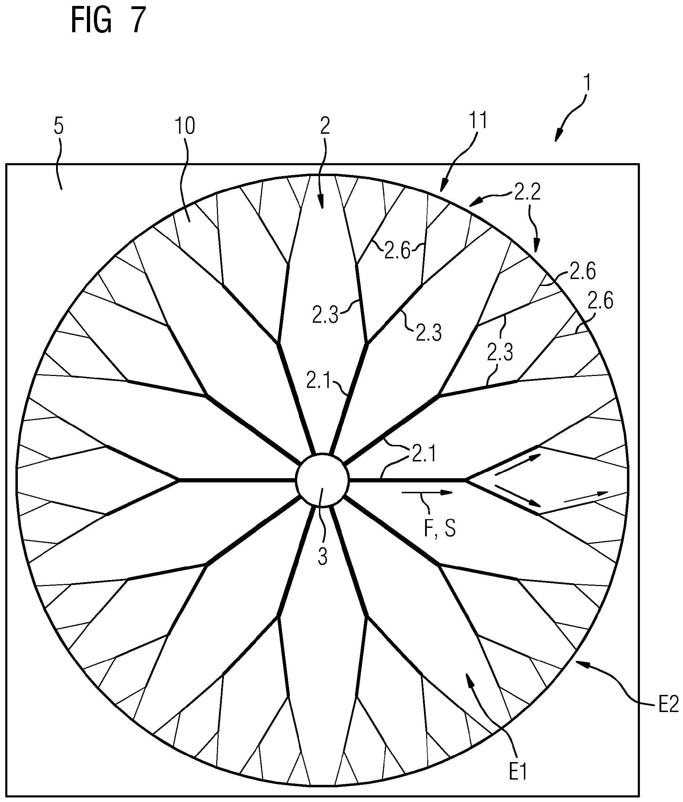

FIG 7 zeigt schematisch in Draufsicht eine weitere alternative Ausführungsform für eine Wärmeübertragungsvorrichtung 1 mit einer wärmeableitenden Struktur 2, welche in zwei Ebenen E1, E2 verläuft. Beispielsweise verlaufen die Ausgangskanäle 2.1 in einer ersten Ebene E1 und die von den Ausgangskanälen 2.1 abgehenden Rücklaufkanäle 2.3 und die von den Rücklaufkanälen 2.3 wieder abgehenden Teilrücklaufkanäle 2.6 in einer zu der ersten Ebene E1 versetzten zweiten Ebene E2.

Mit anderen Worten: Der oder die Rücklaufkanäle 2.3 und Teilrücklaufkanäle 2.6 werden in der zweiten Ebene E2, die tiefer als die erste Ebene E1 liegt, zurückgeführt. Dadurch entsteht eine wärmeableitende Struktur 2 mit mindestens zwei übereinander liegenden Kanalstrukturen - einer oberen Ausgangskanalstruktur und einer darunter liegenden Rücklaufkanalstruktur. Dabei sind weitere fraktale und/oder dreidimensionale Geometrien für die wärmeableitende Struktur 2 möglich. Die FIG 7 zeigt die wärmeableitende Struktur 2 in Form einer Kapillarkanalstruktur 11 mit stark verzweigen Rücklaufkanälen 2.3 und Teilrücklaufkanälen 2.6, die kleiner dimensioniert sind als der jeweilige Ausgangskanal 2.1.

Allen Ausführungsformen nach Figuren 1 bis 7 ist gleich, dass sich die wärmeableitende Struktur 2 radial weg von der Wärmekammer 3 erstreckt, wobei die Wärmekammer 3 unterhalb des Bauteils 4 angeordnet ist.

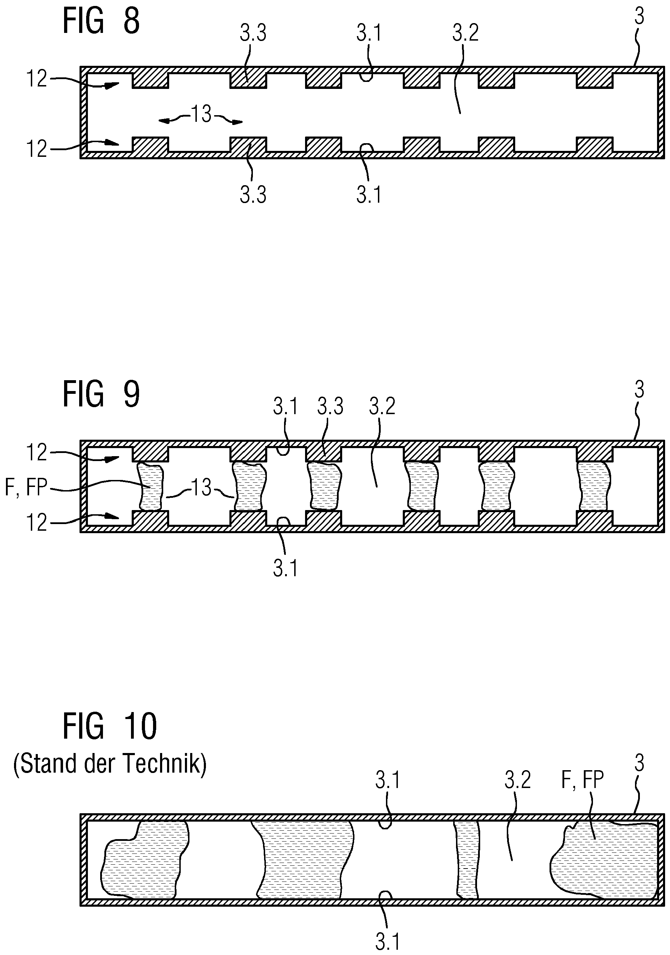

FIG 8 zeigt schematisch in Schnittdarstellung die Wärmekammer 3 mit einer Struktur 12. Die Struktur 12 ist in Form einer Oberflächenstruktur an mindestens einer oder an einander gegenüberliegenden Innenoberflächen 3.1 der Wärmekammer 3 vorgesehen.

Die Struktur 12 ist eine innenseitige Oberflächenstruktur, die in die Wärmekammer 3 hineinragt. Beispielsweise ist die Struktur 12 derart ausgebildet, dass ein Innenraum 3.2 der Wärmekammer 3 einen variierenden Querschnitt aufweist.

Beispielsweise kann der Innenraum 3.2 entlang einer Längsausdehnung mehrere Querschnittsverengungen 13 aufweisen. Die Querschnittsverengungen 13 sind beispielsweise durch in den Innenraum 3.2 hineinragende Vorsprünge 3.3, wie zum Beispiel Rippen, Noppen, Stege, gebildet. Dabei sind die Vorsprünge 3.3 paarweise angeordnet, wobei ein Paar von Vorsprüngen 3.3 von einander gegenüberliegenden Innenoberflächen 3.1 in den Innenraum 3.2 hineinragen. Dabei ragen die Paare von Vorsprüngen 3.3 derart in den Innenraum 3.2 hinein, dass deren freie Vorsprungsenden voneinander beabstandet sind, wodurch eine der Querschnittsverengungen 13 im Innenraum 3.2 gebildet ist. Durch derartige punktuelle Querschnittsverengungen 13 erhöht sich die sogenannte Kapillarkraft des Fluids F in den Kanälen des geschlossenen thermischen Kreislaufs 7.

FIG 9 zeigt schematisch in Schnittdarstellung die Wärmekammer 3 mit der innenseitigen Struktur 12 und eine daraus resultierende verbesserte, insbesondere symmetrische Fluidbesetzung in der Wärmekammer 3. Durch die Querschnittsverengungen 13 erhöht sich die Kapillarkraft des Fluides F in der Wärmekammer 3, so dass das Fluid F im Bereich der jeweiligen Querschnittsverengung 13 als Flüssigphase FP vorliegt.

Solch ein Muster von inneren Strukturen 12 im Innenraum 3.2 der Wärmekammer 3 bewirkt eine symmetrische Fluidbesetzung in der Wärmekammer 3 und erleichtert damit das sogenannte Anfahren der Wärmeübertragungsvorrichtung 1 und des pulsierenden Heizstrukturmechanismus bei einem eingefrorenen Fluid F in der Startphase.

FIG 10 zeigt schematisch in Schnittdarstellung eine herkömmliche Wärmekammer 3 ohne innenseitige Struktur 12 und eine daraus resultierende unsymmetrische Fluidbesetzung innerhalb der Wärmekammer 3 nach dem Stand der Technik.

Obwohl die Erfindung im Detail durch bevorzugte Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Wärmeübertragungsvorrichtung (1), umfassend:
- mindestens eine wärmeableitende Struktur (2) und
- mindestens eine Wärmekammer (3),
wobei die wärmeableitende Struktur (2) und die Wärmekammer (3) zu einem geschlossenen thermischen Kreislauf (7) gekoppelt sind,
wobei die wärmeableitende Struktur (2)
- einen Ausgangskanal (2.1) umfasst, der von der Wärmekammer (3) abgeht und der an einem von der Wärmekammer (3) abgewandten Ende (2.2) in mindestens einen Rücklaufkanal (2.3) mündet, und
wobei der Rücklaufkanal (2.3) kleiner dimensioniert ist als der Ausgangskanal (2.1) und in die Wärmekammer (3) mündet.

2. Wärmeübertragungsvorrichtung (1) nach Anspruch 1, wobei sich der Ausgangskanal (2.1) an dem von der Wärmekammer (3) abgewandten Ende (2.2) in mindestens zwei oder mehr Rücklaufkanäle (2.3) aufteilt, welche jeweils kleiner dimensioniert sind als der Ausgangskanal (2.1) und welche getrennt voneinander in die Wärmekammer (3) münden.

3. Wärmeübertragungsvorrichtung (1) nach Anspruch 1 oder 2, wobei der Ausgangskanal (2.1) und der mindestens eine Rücklaufkanal (2.3) in einer Ebene (E, E1) liegen.

4. Wärmeübertragungsvorrichtung (1) nach Anspruch 1 oder 2, wobei der Ausgangskanal (2.1) in mindestens einer ersten Ebene (E1) verläuft und der mindestens eine Rücklaufkanal (2.3) in mindestens einer zu der mindestens ersten Ebene (E1) versetzten zweiten Ebene (E2) verläuft.

5. Wärmeübertragungsvorrichtung (1) nach einem der vorhergehenden Ansprüche, wobei ein Innendurchmesser (D1) des Ausgangskanals (2.1) größer ist als ein Innendurchmesser (D2) des mindestens einen Rücklaufkanals (2.3).

6. Wärmeübertragungsvorrichtung (1) nach einem der vorhergehenden Ansprüche, wobei die Wärmekammer (3) als eine Siede- oder Dampfkammer ausgebildet ist, welche an mindestens einer oder einander gegenüberliegenden Innenoberflächen (3.1) mit einer Struktur (12) versehen ist.

7. Wärmeübertragungsvorrichtung (1) nach Anspruch 6, wobei die Struktur (12) derart ausgebildet ist, dass ein Innenraum (3.2) der Wärmekammer (3) einen variierenden Querschnitt aufweist.

8. Wärmeübertragungsvorrichtung (1) nach Anspruch 6 oder 7, wobei ein Innenraum (3.2) der Wärmekammer (3) entlang einer Längsausdehnung mehrere Querschnittsverengungen (13) aufweist.

9. Wärmeübertragungsvorrichtung (1) nach Anspruch 8, wobei die Querschnittsverengungen (13) durch einander gegenüberliegende Vorsprünge (3.3) gebildet sind, die von einander gegenüberliegenden Innenoberflächen (3.1) in den Innenraum (3.2) hineinragen.

10. Wärmeübertragungsvorrichtung (1) nach einem der vorhergehenden Ansprüche, wobei die mindestens eine Wärmekammer (3) eine Siede- oder Dampfkammer ist und die mindestens eine wärmeableitende Struktur (2) eine Kanalstruktur mit Dampfbereichen (2.4) und Flüssigbereichen (2.5) ist, wobei die Wärmekammer (3) und die wärmeableitende Struktur (2) zusammen eine pulsierenden oder oszillierenden Heizstrukturmechanismus bilden.

11. Wärmeübertragungsvorrichtung (1) nach einem der vorhergehenden Ansprüche, wobei die wärmeableitende Struktur (2) symmetrisch oder asymmetrisch um die Wärmekammer (3) angeordnet ist.

12. Elektrisches oder elektronisches Bauteil (4), umfassend ein Leistungselement, insbesondere ein Leistungshalbleiterelement, welches thermisch mit einer Wärmeübertragungsvorrichtung (1) nach einem der vorhergehenden Ansprüche gekoppelt ist.

13. Elektrisches oder elektronisches Bauteil (4) nach Anspruch 12, wobei die Wärmeübertragungsvorrichtung (1) unterhalb, oberhalb oder innerhalb des Leistungselements angeordnet ist.

14. Elektrisches oder elektronisches Bauteil (4) nach Anspruch 12 oder 13, wobei die Wärmekammer (3) unterhalb, oberhalb oder innerhalb des Leistungselements zu diesem angeordnet ist.

15. Elektrisches oder elektronisches Bauteil (4) nach einem der vorhergehenden Ansprüche 12 bis 14, wobei die wärmeableitende Struktur (2) sich radial weg von der Wärmekammer (3) und dem Leistungselement in einer oder mehreren Ebenen (E, E1 bis E2) erstreckt.
